# EUROPÄISCHE PATENTANMELDUNG

(11) **EP 1 102 403 A1**
(43) Veröffentlichungstag der Anmeldung: **23.05.2001**
(21) Anmeldenummer: 99811073.8
(22) Anmeldetag: 19.11.1999
(51) Int. Cl.: H03M 1/10, H02H 3/04

(54) **Funktionsüberwachung eines Wandlers**

(71) Anmelder: ABB Power Automation AG, 5401 Baden (CH)
(72) Erfinder: Wenning, Guido, 8049 Zürich (CH)
(74) Vertreter: ABB Patent Attorneys

(57) **Zusammenfassung**

Bei einer Funktionsüberwachung eines Wandlers (1) wird detektiert, ob ein Wert einer Eingangsgrösse (2) des Wandlers (1) einen ersten vorgegebenen Eingangsreferenzwert (41) annimmt, und überprüft, ob eine Ausgangsgrösse (3) des Wandlers (1) ebenfalls einen entsprechenden, zweiten vorgegebenen Ausgangsreferenzwert (61) annimmt.

Somit findet nur zu vereinzelten Zeitpunkten eine Prüfung der Wandlerfunktion statt, und zwar nur anhand einzelner, vorgegebener Werte. Dadurch, dass nur vorgegebene Werte (41,61) mit Momentanwerten der Eingangs- respektive Ausgangsgrösse (2,3) verglichen werden, kann die Erfindung mit sehr einfachen Mitteln realisert weren.

Das erfindungsgemässe Verfahren eignet sich insbesondere zur Funktionsüberwachung eines Wandlers (1) einer Steuer- oder Schutzeinrichtung einer elektrischen Schaltanlage eingesetzt. Dabei werden vorzugsweise bei einer Detektion einer Fehlfunktion des Wandlers (1) alle Schutzfunktionen, welche auf den Wandler (1) angewiesen sind, ausgeschaltet.

## Beschreibung

### Technisches Gebiet

Die Erfindung bezieht sich auf das Gebiet der Schutztechnik, insbesondere für elektrische Schaltanlagen. Sie bezieht sich auf eine Vorrichtung und ein Verfahren zur Funktionsüberwachung eines Wandlers gemäss dem Oberbegriff der Patentansprüche 1 und 5.

### Stand der Technik

Elektrische Schaltanlagen, beispielsweise Mittel-, Hoch- und Niederspannungsschaltanlagen, weisen Steuer- und Schutzeinrichtungen auf. Schutzeinrichtungen müssen elektrische Störfälle, beispielsweise Kurzschlüsse oder Leitungsunterbrüche, zuverlässig detektieren, identifizieren und orten, und müssen geeignete Gegenmassnahmen auslösen, um eine Fortpflanzung von Störungen und eine Zerstörung von Anlagenteilen zu verhindern. Gleichzeitig soll aber eine Schutzeinrichtung keine unnötigen Abschaltungen von Anlagenteilen auslösen. Deshalb muss auch eine Schutzeinrichtung selber eine hohe Zuverlässigkeit aufweisen. Dazu müssen einzelne Einheiten der Schutzeinrichtung, insbesondere Wandler, überwacht werden. Solche Wandler sind beispielsweise Messverstärker, Digital-Analog- oder Analog-Digital-Wandler. Ein Defekt eines Wandlers führt im Allgemeinen zu einer Verfälschung von Messdaten und zu einem Fehlverhalten der Schutzeinrichtung.

In allgemein bekannter Weise geschieht eine Funktionsüberwachung durch redundante Ausführung von Einheiten einer Einrichtung: Eine solche Einheit wird doppelt oder dreifach ausgeführt, und aus einer fehlenden Übereinstimmung von Ausgangssignalen der Einheiten wird auf eine Fehlfunktion einer Einheit geschlossen. Eine solche Redundanz führt jedoch mindestens zu einer Verdoppelung respektive Verdreifachung der Kosten der Einheit.

Eine andere Art der Überwachung einer Gerätefunktion ist aus der US-4,21 5,412 bekannt. Dabei werden während eines Betriebes eines Flugzeugtriebwerks Steuergrössen und Ausgangsgrössen des Triebwerkes gemessen. Ein rechnerbasiertes Simulationsmodell des Triebwerks bildet während des Betriebes anhand der gemessenen Steuergrössen kontinuierlich ein Verhalten des Triebwerks und der Ausgangsgrössen nach. Dazu wird ein aufwändiges mathematisches Modell mit entsprechendem Rechenaufwand verwendet. Falls die sich dauernd ändernden berechneten und gemessenen Ausgangsgrössen nicht übereinstimmen, wird eine Anzeige für einen Bediener aktiviert. Es erfordert jedoch einen hohen Aufwand, ein Simulationsmodell zu erstellen, an ein gegebenes Triebwerk anzupassen, und während des Betriebes durchzurechnen.

### Darstellung der Erfindung

Es ist deshalb Aufgabe der Erfindung, eine Vorrichtung und ein Verfahren zur Funktionsüberwachung eines Wandlers der eingangs genannten Art zu schaffen, welche die oben genannten Nachteile behebt.

Diese Aufgabe lösen eine Vorrichtung und ein Verfahren zur Funktionsüberwachung eines Wandlers mit den Merkmalen der Patentansprüche 1 und 5.

Im erfindungsgemässen Verfahren zur Funktionsüberwachung eines Wandlers wird detektiert, ob ein Wert einer Eingangsgrösse des Wandlers einen ersten vorgegebenen Eingangsreferenzwert annimmt, und überprüft, ob eine Ausgangsgrösse des Wandlers ebenfalls einen entsprechenden, zweiten vorgegebenen Ausgangsreferenzwert annimmt.

Somit findet nur zu vereinzelten Zeitpunkten eine Prüfung der Wandlerfunktion statt, und zwar nur anhand einzelner, vorgegebener Werte. Dadurch, dass nur vorgegebene Werte mit Momentanwerten der Eingangs- respektive Ausgangsgrösse verglichen werden, kann die erfindungsgemässe Vorrichtung mit sehr einfachen Mitteln realisiert werden.

In einer bevorzugten Variante der Erfindung entsprechen die vorgegebenen Werte einem Wert Null eines Stromes, oder einem Wert Null einer Spannung, also einem Erdpotential, und/oder einer Versorgungsspannung einer elektrischen Anlage.

Das erfindungsgemässe Verfahren eignet sich insbesondere zur Funktionsüberwachung eines Wandlers einer Steuer- oder Schutzeinrichtung einer elektrischen Schaltanlage. Dabei werden bei einer Detektion einer Fehlfunktion des Wandlers vorzugsweise alle Schutzfunktionen, welche auf diesen Wandler angewiesen sind, ausgeschaltet.

Weitere bevorzugte Ausführungsformen gehen aus den abhängigen Patentansprüchen hervor.

### Kurze Beschreibung der Zeichnungen

Im folgenden wird die Erfindung anhand bevorzugter Ausführungsbeispiele, welche in den beiliegenden Zeichnungen dargestellt sind, näher erläutert. Es zeigen:
- Figur 1: schematisch eine Struktur eines Wandlers mit einer erfindungsgemässen Überwachungsvorrichtung;
- Figur 2: einen zeitlichen Verlauf von Signalen gemäss der Erfindung;
- Figuren 3 und 4: Strukturen von Wandlereinheiten mit einer erfindungsgemässen Überwachung; und
- Figur 5: schematisch eine Struktur eines Wandlers mit mehreren Wandlerstufen und einer erfindungsgemässen Überwachungsvorrichtung.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

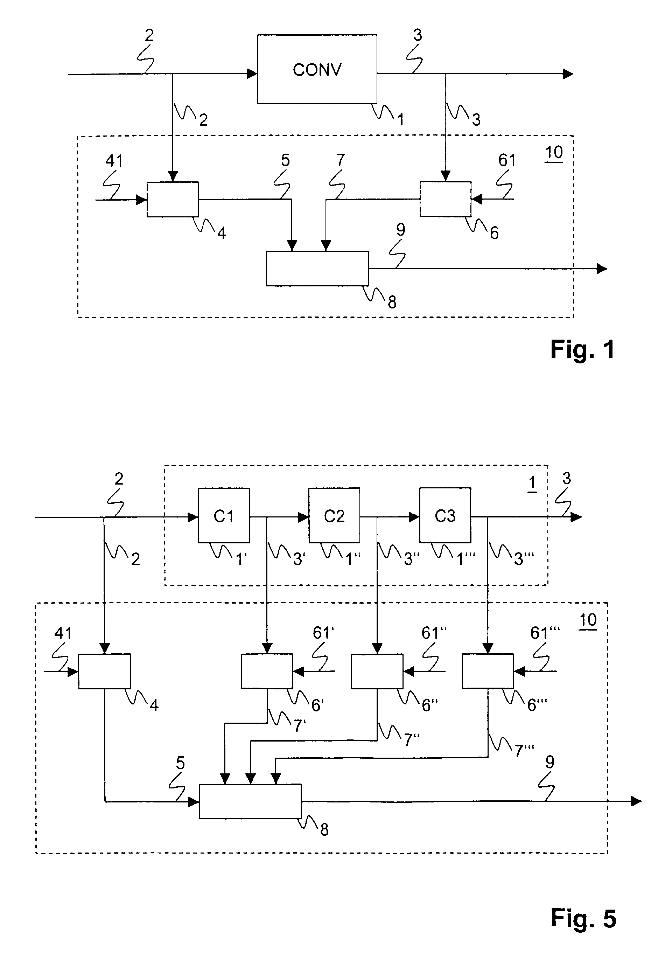

Figur 1 zeigt schematisch eine Struktur eines Wandlers 1 mit einer erfindungsgemässen Überwachungsvorrichtung 10. Eine Eingangsgrösse 2 des Wandlers 1 und ein Eingangsreferenzwert 41 führen auf einen Eingangsdetektor 4. Eine Ausgangsgrösse 3 des Wandlers 1 und ein Ausgangsreferenzwert 61 führen auf einen Ausgangsdetektor 6. Ein digitales Eingangsflag 5 des Eingangsdetektors 4 und ein digitales Ausgangsflag 7 des Ausgangsdetektors 6 führen auf eine Auswerteeinheit 8 zur Erzeugung eines Statussignals 9. Optional führt das Eingangsflag 5 auch auf den Ausgangsdetektor 6.

Das erfindungsgemässe Verfahren funktioniert wie folgt: Der Eingangsdetektor 4 überwacht dauernd die Eingangsgrösse 2. Solange ein Wert der Eingangsgrösse 2 innerhalb eines vorgegebenen Toleranzbereiches um den Eingangsreferenzwert 41 liegt, setzt der Eingangsdetektor 4 das Eingangsflag 5 auf einen vorgegebenen Wert, beispielsweise auf den Wert Null. Falls der Wert der Eingangsgrösse 2 annähernd gleich dem Eingangsreferenzwert 41 ist, das heisst, falls er innerhalb des vorgegebenen Toleranzbereiches um den Eingangsreferenzwert 41 liegt, detektiert der Eingangsdetektor 4 eine Übereinstimmung der Eingangsgrösse 2 mit dem Eingangsreferenzwert 41. Der Eingangsdetektor 4 spricht somit an und setzt das Eingangsflag 5 auf einen anderen Wert, beispielsweise auf den Wert eins. Der Ausgangsdetektor 6 vergleicht in gleicher Weise einen Wert der Ausgangsgrösse 3 dauernd mit dem Ausgangsreferenzwert 61. Der Ausgangsdetektor 6 bildet das Ausgangsflag 7 zur Anzeige einer Übereinstimmung der Ausgangsgrösse 3 mit dem Ausgangsreferenzwert 61, also zur Anzeige, ob die Ausgangsgrösse 3 innerhalb eines vorgegebenen Toleranzbereiches um den Ausgangsreferenzwert 61 liegt. In einer Variante des erfindungsgemässen Verfahrens geschieht der Vergleich der Ausgangsgrösse 3 nur dann, wenn die optionale Verbindung des Eingangsflags 5 zum Ausgangsdetektor 6 ein Ansprechen des Eingangsdetektors 4 anzeigt. Die Auswerteeinheit 8 erhält das Eingangsflag 5 und das Ausgangsflag 7 und bildet daraus das Statussignal 9 in folgender Weise: Wenn das Eingangsflag 5 und das Ausgangsflag 7 beide ein Ansprechen des entsprechenden Detektors 4,6 anzeigen, so wird durch das Statussignal 9 ein korrektes Funktionieren des Wandlers 1 übermittelt. Wenn das Eingangsflag 5 und das Ausgangsflag 7 nicht übereinstimmen, so wird durch das Statussignal 9 eine Fehlfunktion des Wandlers 1 übermittelt. Auch die Bildung des Statussignals 9 kann entweder dauernd geschehen, oder aber nur dann, wenn das Eingangsflag 5 ein Ansprechen des Eingangsdetektors 4 anzeigt.

In einer Variante der Erfindung wird der Vergleich im Ausgangsdetektor 6 dauernd durchgeführt, und wird der Vergleich im Eingangsdetektor 4 und/oder die Bildung des Statussignals 9 nur dann durchgeführt, wenn der Ausgangsdetektor 6 anspricht.

In einer weiteren Variante der Erfindung berücksichtigt die Auswerteeinheit 8 eine Verzögerungszeit des Wandlers und vergleicht das Eingangsflag 5 mit einem erst nach dieser Verzögerungszeit auftretenden Wert des Ausgangsflags 7. Somit geschieht die Bestimmung, ob sowohl die Eingangsgrösse 2 als auch die Ausgangsgrösse 3 innerhalb des jeweiligen vorgegebenen Toleranzbereiches liegen, entsprechend von Werten der Eingangsgrösse 2 und von Werten der Ausgangsgrösse 3, welche um eine Verzögerungszeit des Wandlers 1 zueinander verschoben bestimmt wurden.

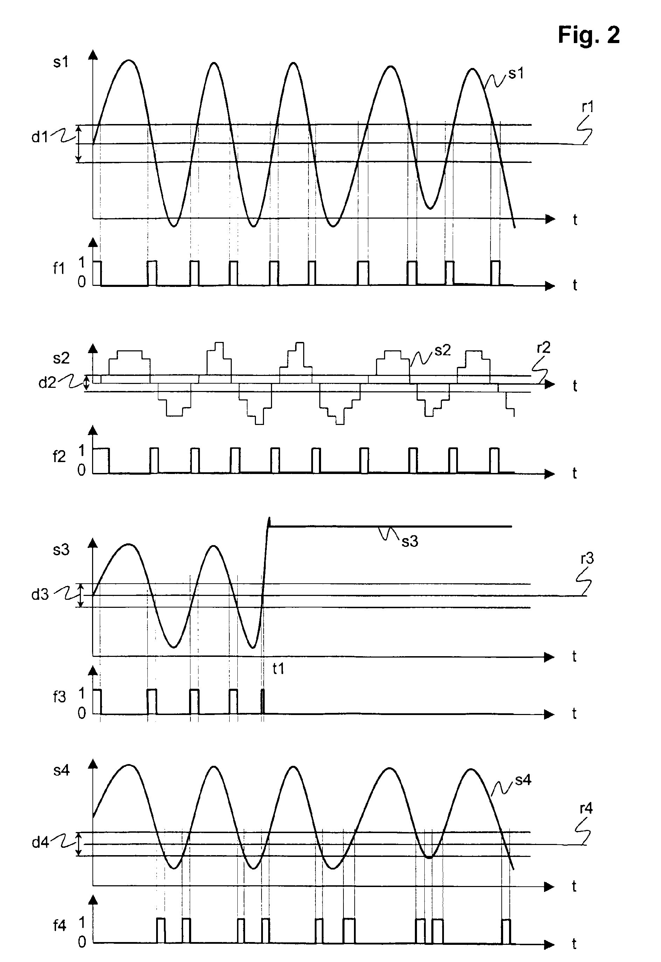

Figur 2 zeigt entlang einer horizontalen Zeitachse t einen Verlauf s1 einer ersten Grösse, einen ersten Referenzwert r1, einen ersten Toleranzbereich dl und ein Verlauf f1 eines ersten Flags, einen Verlauf s2 einer zweiten Grösse, einen zweiten Referenzwert r2, einen zweiten Toleranzbereich d2 und ein zweites Flag f2, einen Verlauf s3 einer dritten Grösse, einen dritten Referenzwert r3, einen dritten Toleranzbereich d3 und ein drittes Flag f3, sowie einen Verlauf s4 einer vierten Grösse, einen vierten Referenzwert r4, einen vierten Toleranzbereich d4 und ein viertes Flag f4. Das erste respektive zweite Flag f1,f2 werden in der oben beschriebenen Weise nur dann auf einen Wert eins gesetzt, wenn sich die erste respektive zweite Grösse sl,s2 innerhalb des ersten respektive zweiten Toleranzbereiches dl,d2 um den ersten respektive zweiten Referenzwert r1,r2 befindet. Das Gleiche gilt analog für das dritte und vierte Flag f3,f4.

Die erste Grösse weist einen kontinuierlichen Verlauf s1 ihrer Werte auf, die zweite Grösse weist diskrete Werte s2 auf. Die erste und zweite Grösse entsprechen beispielsweise einer Eingangsgrösse 2 respektive einer Ausgangsgrösse 3 eines funktionierenden Analog-Digital-Wandlers 1. Dabei liegt die Ausgangsgrösse des Wandlers 1 digital codiert vor. In einer anderen Variante der Erfindung ist der Wandler 1 ein Analogverstärker und entsprechen bei funktionierendem Wandler 1 die Verläufe der Eingangsgrösse 2 und der Ausgangsgrösse 3 beide annähernd dem Verlauf der ersten Grösse. In einer weiteren Variante der Erfindung ist der Wandler 1 ein Digital-Analog-Wandler und entsprechen bei funktionierendem Wandler 1 die Verläufe der Eingangsgrösse 2 und der Ausgangsgrösse 3 beide annähernd dem Verlauf der zweiten Grösse.

Falls der Wandler 1 nicht funktioniert, indem er die Ausgangsgrösse 3 nach einem Zeitpunkt t1 dauernd in ein Maximum oder ein Minimum treibt, übersteuert, so tritt ein Verlauf der Ausgangsgrösse 3 entsprechend dem Verlauf s3 auf. Der entsprechende Verlauf f3 eines Ausgangsflags 7 zeigt, dass der Ausgangsdetektor 6 nach dem Zeitpunkt t1 nie anspricht. Somit tritt auch keine Übereinstimmung von Eingangsflags 5 mit Ausgangsflags 7 auf. Dadurch wird eine Fehlfunktion des Wandlers 1 detektiert und durch Setzen des Statussignals 9 übermittelt.

Falls der Wandler 1 nicht funktioniert, indem die Ausgangsgrösse 3 einen zu grossen Offset aufweist, so tritt bei einem Verlauf einer Eingangsgrösse 2 gemäss s1 oder s2 ein Verlauf der Ausgangsgrösse 3 entsprechend dem Verlauf s4 auf. Der entsprechende Verlauf f4 eines Ausgangsflags 7 zeigt, dass der Ausgangsdetektor 6 zu anderen Zeitpunkten als ein Eingangsdetektor 4 bei einem Verlauf gemäss s1 anspricht. Somit tritt auch hier keine Übereinstimmung von Eingangsflags 5 mit Ausgangsflags 7 auf. Dadurch wird eine Fehlfunktion des Wandlers 1 detektiert und durch Setzen des Statussignals 9 übermittelt.

Die Referenzwerte 41, 61 werden durch einen Abgleich des Wandlers 1, beispielsweise bei einer Inbetriebnahme, bestimmt. Falls der Wandler 1 ein Analog-Digital-Wandler ist, wird der Eingangsgrösse 2 als vorgegebener Wert bevorzugt ein Wert Null aufgeschaltet, beispielsweise ein Erdpotential oder ein Strom Null. Als Eingangsreferenzwert 41, bei welchem der Eingangsdetektor 4 anspricht, wird ebenfalls ein Wert Null definiert. Aufgrund eines Offsets des Wandlers 1 ergibt sich ein bestimmter, Wert der Ausgangsgrösse 3, der im allgemeinen von Null verschieden ist. Dieser Wert der Ausgangsgrösse 3 wird als Ausgangsreferenzwert 61 gewählt, bei welchem der Ausgangsdetektor 6 anspricht. Der Ausgangsreferenzwert 61 entspricht dem Eingangsreferenzwert 41 Null. Falls der Wandler 1 ein Digital-Analog-Wandler ist, wird die Eingangsgrösse 2 variiert, bis die Ausgangsgrösse 3 einen Wert Null aufweist. Der entsprechende Wert der Eingangsgrösse 2 wird als Eingangsreferenzwert 41 gewählt und einem Ausgangsreferenzwert 61 Null zugeordnet. In ähnlicher Weise geschieht ein Abgleich, welcher anstelle eines Erdpotentials eine Versorgungsspannung oder eine Nennspannung einer Anlage als Referenzwert einer Analogseite eines Wandlers 1 verwendet.

Die erfindungsgemässe Überwachungsvorrichtung 10 zur Funktionsüberwachung eines Wandlers 1, wobei der Wandler 1 ein Analogwandler oder ein bestehender Wandler 1 einer Anlage ist, weist somit
- einen Eingangsdetektor 4 zur Erzeugung des Eingangsflags 5 entsprechend einer Detektion des Eingangsreferenzwertes 41 der Eingangsgrösse 2 des Wandlers 1,
- einen Ausgangsdetektor 6,6',6",6"' zur Erzeugung eines Ausgangsflags 7,7',7",7"' entsprechend einer Detektion eines Ausgangsreferenzwertes 61,61',61",61"' einer dem Ausgangsdetektor 6,6',6",6"' zugeordneten Ausgangsgrösse 3,3',3",3"' des Wandlers 1 sowie
- eine Auswerteeinheit 8 zum Vergleich der Resultate der Detektoren, also der Ein- und Ausgangsflags 5,7,7',7",7"', und zur Erzeugung eines Statussignals 9 zur Übermittlung einer Übereinstimmung der Flags 5,7,7',7" ,7"'
auf.

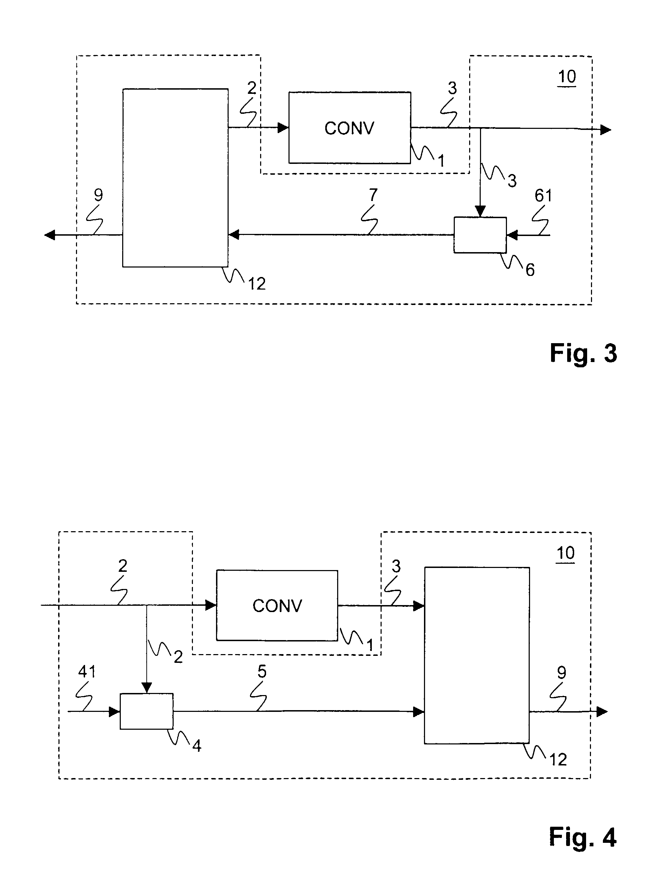

Figur 3 zeigt eine bevorzugte Variante der Erfindung: Eine Überwachungsvorrichtung 10 weist einen Wandler 1, einen Ausgangsdetektor 6 und eine Digitaleinheit 12 auf. Der Wandler 1 ist ein Digital-Analog-Wandler, der die Eingangsgrösse 2 von der Digitaleinheit 12 in digital codierter Form erhält. Die Digitaleinheit 12 erhält die Eingangsgrösse 2 über einen nicht gezeigten Eingang übermittelt, oder erzeugt die Eingangsgrösse 2 selber. Der Ausgangsdetektor 6 ist ein analoger Baustein, welcher das Ausgangsflag 7 oder Analogflag der Digitaleinheit 12 übermittelt. Das Analogflag zeigt eine Übereinstimmung der Ausgangsgrösse 3 mit dem Ausgangsreferenzwert 61 an. Die Digitaleinheit 12 weist eine programmierbare Recheneinheit wie einen Mikroprozessor oder einen ASIC (Application-Specific Integrated Circuit) oder FPGA (Field Programmable Gate Array) und/oder eine speziell ausgelegte digitale Schaltung auf. Die oben beschriebenen Funktionen des Eingangsdetektors 4 und der Auswerteeinheit 8 sind in der Digitaleinheit 12 realisiert. Dazu bildet sie ein vorzugsweise ein Digitalflag, welches eine Übereinstimmung der Eingangsgrösse 2 mit dem Eingangsreferenzwert 41 anzeigt. Das Digitalflag wird vorzugsweise durch eine interne Variable oder ein internes Signal der Digitaleinheit 12 realisiert.

Figur 4 zeigt eine weitere bevorzugte Variante der Erfindung. Eine Überwachungsvorrichtung 10 weist einen Wandler 1, einen Eingangsdetektor 4 und eine Digitaleinheit 12 auf. Der Wandler 1 ist ein Analog-Digital-Wandler, der die Ausgangsgrösse 3 in digital codierter Form an eine Digitaleinheit 12 übermittelt. Die Digitaleinheit 12 übermittelt die Ausgangsgrösse 3 über einen nicht gezeigten Ausgang und/oder verarbeitet sie selber. Der Eingangsdetektor 4 ist ein analoger Baustein, welcher das Eingangsflag 5 oder Analogflag der Digitaleinheit 12 übermittelt. Das Analogflag zeigt eine Übereinstimmung der Eingangsgrösse 2 mit dem Eingangsreferenzwert 41 an. Die Digitaleinheit 12 weist eine programmierbare Recheneinheit wie einen Mikroprozessor oder einen ASIC oder FPGA und/oder eine speziell ausgelegte digitale Schaltung auf. Die oben beschriebenen Funktionen des Ausgangsdetektors 6 und der Auswerteeinheit 8 sind in der Digitaleinheit 12 realisiert. Dazu bildet sie ein Digitalflag, welches eine Übereinstimmung der Ausgangsgrösse 3 mit dem Ausgangsreferenzwert 61 anzeigt. Das Digitalflag wird vorzugsweise durch eine interne Variable oder ein internes Signal der Digitaleinheit 12 realisiert.

Figur 5 zeigt eine weitere bevorzugte Variante der Erfindung. Darin besteht der Wandler 1 aus mehreren kaskadierten Teilwandlern 1',1",1"', deren Ausgangsgrössen 3',3",3"' auf Ausgangsdetektoren 6',6",6"' zur Bildung von Ausgangsflags 7',7",7"' geführt werden. Das Eingangsflag 5 und die Ausgangsflags 7',7",7"'werden durch die Auswerteeinheit 8 ausgewertet, welche bei einer fehlenden Übereinstimmung des Eingangsflags 5 und/oder der Ausgangsflags 7',7",7"' auf eine Fehlfunktion eines Teilwandlers 1',1",1"' schliesst.

In einer bevorzugten Variante der Erfindung entsprechen die vorgegebenen Referenzwerte einem Wert Null eines Stromes, oder einem Wert Null einer Spannung, also einem Erdpotential, und/oder einer Versorgungsspannung einer elektrischen Anlage. Solche Referenzwerte haben den Vorteil, dass sie überall in einer Anlage auftreten und definiert sind. Falls ein Referenzwert einer analogen Grösse einem Erdpotential oder einem Wert Null entspricht, so ist der analoge Detektor einfach ein analoger Komparator, dessen Umschaltschwelle gleich einer oberen Grenze des vorgegebenen Toleranzbereiches um den Referenzwert Null ist. Unterschreitet ein Absolutwert der analogen Grösse die obere Grenze des Toleranzbereiches, so setzt der Komparator sein Ausgangssignal oder Analogflag auf den Wert eins und zeigt damit an, dass die analoge Grösse den vorgegebenen Referenzwert Null aufweist.

Das erfindungsgemässe Verfahren eignet sich insbesondere zur Funktionsüberwachung eines Wandlers einer Steuer- oder Schutzeinrichtung einer elektrischen Schaltanlage. Beispielsweise werden Digital-Analog-Wandler 1 eingesetzt, um digital über Glasfasern übertragene Signale 2 von Schutzgeräten in Analogsignale 3 umzusetzen. Diese Analogsignale 3 werden auf Analogeingänge von bestehenden älteren Schutzgeräten geführt. Vorzugsweise wird eine erfindungsgemässe Überwachungsvorrichtung 10 gemäss der Struktur von Figur 3 für einen solchen Digital-Analog-Wandler 1 eingesetzt. Vorzugsweise werden damit Spannungen anhand von Referenzwerten Null, welche Erdpotential entsprechen, überwacht. Auch Ströme werden vorzugsweise anhand von Referenzwerten Null überwacht. Für einen Abgleich einer Überwachung eines Wandlers 1, welcher eine Strommessung verarbeitet, wird ein entsprechender Leitungsabschnitt stromlos geschaltet.

Eine Fehlfunktion eines Wandlers 1, der zu einer Übersteuerung der Ausgangsgrösse 3 des Wandlers 1 führt, lässt sich im Falle eines Wandlers 1, welcher eine Strommessung verarbeitet, nicht kurzfristig, das heisst, in einer Zeit während der eine Schutzeinrichtung reagieren muss, von einem Kurzschlusstrom in der Anlage unterscheiden. Hier erlaubt die Erfindung, die Fehlfunktion zu detektieren.

Bei einer Funktionsüberwachung eines Wandlers 1 einer Schutzeinrichtung einer elektrischen Schaltanlage wird vorzugsweise bei einer Detektion einer Fehlfunktion des Wandlers 1 die Ausgangsgrösse 3 als ungültig markiert, beispielsweise durch Übermittlung eines entsprechenden Statussignals. Vorzugsweise werden in diesem Fall Schutzfunktionen, welche auf den Wandler 1 angewiesen sind, ausgeschaltet. Dies ist zulässig, weil Störfälle in Schaltanlagen sehr selten auftreten. Vorteilhafterweise ist dabei das Risiko einer Betriebsstörung durch einen defekten Wandler 1 grösser ist als das Risiko eines nicht optimal erfassten Störfalls.

Die Erfindung hat den Vorteil, dass eine Überwachung mit sehr einfachen Mitteln realisierbar ist. Beispielsweise wird für einen Digital-Analog-Wandler oder einen Analog-Digital-Wandler nur ein zusätzlicher analoger Baustein benötigt, währenddem die übrigen Funktionen in einer ohnehin vorhandenen, beispielsweise programmierbaren, Digitaleinheit 12 realisiert werden. Auch ist eine erfindungsgemässe Überwachung nachträglich bei einem bestehenden Wandler implementierbar.

### Bezugszeichenliste

- 1: Wandler
- 1',1",1"': Teilwandler
- 2: Eingangsgrösse
- 3,3',3",3"': Ausgangsgrösse
- 4: Eingangsdetektor
- 5: Eingangsflag
- 6,6',6",6"': Ausgangsdetektor
- 7,7',7",7"': Ausgangsflag
- 8: Auswerteeinheit
- 9: Statussignal
- 10: Überwachungsvorrichtung
- 12: Digitaleinheit
- 41: Eingangsreferenzwert
- 61,61',61",61"': Ausgangsreferenzwert
- s1,s2,s3,s4: erster, zweiter, dritter und vierter Verlauf
- r1,r2,r3,r4: erster, zweiter. dritter und vierter Referenzwert
- d1,d2,d3,d4: erster, zweiter, dritter und vierter Toleranzbereich
- f1 ,f2,f3,f4: erstes, zweites, drittes und viertes Flag

## Patentansprüche

1. Überwachungsvorrichtung (10) zur Funktionsüberwachung eines Wandlers (1) mit Mitteln zur Überwachung einer Eingangsgrösse (2) und mindestens einer Ausgangsgrösse (3,3',3",3"'), dadurch gekennzeichnet, dass die Überwachungsvorrichtung (10) einen Eingangsdetektor (4) zur Detektion eines Eingangsreferenzwertes (41) einer Eingangsgrösse (2) des Wandlers (1), einen Ausgangsdetektor (6,6',6",6"') zur Detektion eines Ausgangsreferenzwertes (61,61',61",61"') einer Ausgangsgrösse (3,3',3",3"'), sowie eine Auswerteeinheit (8) zum Vergleich von Resultaten (5,7,7',7",7"') des Eingangsdetektors (4) und des Ausgangsdetektors (6,6',6",6"') und zur Erzeugung eines entsprechenden Statussignals (9), welches ein korrektes Funktionieren respektive eine Fehlfunktion des Wandlers (1) übermittelt, aufweist.

2. Überwachungsvorrichtung (10) gemäss Anspruch 1, dadurch gekennzeichnet, dass die vorgegebenen Referenzwerte (41,61,61',61",61"') einem Wert Null einer Spannung oder eines Stromes entsprechen.

3. Überwachungsvorrichtung (10) gemäss Anspruch 1, dadurch gekennzeichnet, dass der Wandler (1) ein Digital/Analog-Wandler ist, der Ausgangsdetektor (6,6',6",6"') ein analoger Detektor ist, und der Eingangsdetektor (4) und die Auswerteinheit (8) in einer Digitaleinheit (12) realisiert sind.

4. Überwachungsvorrichtung (10) gemäss Anspruch 1, dadurch gekennzeichnet, dass der Wandler (1) ein Analog/Digital-Wandler ist, der Eingangsdetektor (4) ein analoger Detektor ist, und der Ausgangsdetektor (6,6',6",6"') und die Auswerteinheit (8) in einer Digitaleinheit (12) realisiert sind.

5. Verfahren zur Funktionsüberwachung eines Wandlers (1), dadurch gekennzeichnet,
dass bestimmt wird, ob eine Eingangsgrösse (2) des Wandlers (1) innerhalb eines ersten vorgegebenen Toleranzbereiches um einen Eingangsreferenzwert (41) liegt,
dass bestimmt wird, ob eine Ausgangsgrösse (3) des Wandlers (1) innerhalb eines zweiten vorgegebenen Toleranzbereiches um einen Ausgangsreferenzwert (61) liegt, und
dass falls sowohl die Eingangsgrösse (2) wie die Ausgangsgrösse (3) innerhalb des jeweiligen vorgegebenen Toleranzbereiches zum jeweiligen Referenzwert liegen, festgestellt wird, dass ein korrektes Funktionieren des Wandlers (1) vorliegt, und andernfalls, dass eine Fehlfunktion des Wandlers (1) vorliegt.

6. Verfahren gemäss Anspruch 5, dadurch gekennzeichnet, dass der Eingangsreferenzwert (41) oder der Ausgangsreferenzwert (61) einem Wert Null einer Spannung oder eines Stromes entsprechen.

7. Verfahren gemäss Anspruch 5, dadurch gekennzeichnet, dass nach einer Ermittlung einer Fehlfunktion des Wandlers (1) die Ausgangsgrösse (3) als ungültig markiert wird.

8. Verfahren gemäss Anspruch 5, dadurch gekennzeichnet, dass nach einer Ermittlung einer Fehlfunktion des Wandlers (1) Schutzfunktionen einer Schutzeinrichtung einer elektrischen Schaltanlage, welche auf den Wandler (1) angewiesen sind, ausgeschaltet werden.

9. Verfahren gemäss Anspruch 5, dadurch gekennzeichnet, dass die Bestimmung, ob sowohl die Eingangsgrösse (2) wie die Ausgangsgrösse (3) innerhalb des jeweiligen vorgegebenen Toleranzbereiches liegen, entsprechend von Werten der Eingangsgrösse (2) und von Werten der Ausgangsgrösse (3) geschieht, welche um eine Verzögerungszeit des Wandlers (1) zueinander verschoben bestimmt wurden.

10. Verfahren gemäss Anspruch 5, dadurch gekennzeichnet, dass ein Vergleich der Ausgangsgrösse (3) mit dem Ausgangsreferenzwert (61) in Abhängigkeit davon durchgeführt wird, ob die Eingangsgrösse (2) des Wandlers (1) innerhalb des ersten vorgegebenen Toleranzbereiches vom Eingangsreferenzwert (41) liegt.
